# EUROPÄISCHE PATENTANMELDUNG

(11) **EP 4 808 295 A1**
(43) Veröffentlichungstag der Anmeldung: **16.09.2026**
(21) Anmeldenummer: 26164410.8
(22) Anmeldetag: 12.03.2026
(51) Int. Cl.: H05K 5/02, H02B 1/38, H05K 7/16

(54) **SCHWENKBARES ELEKTRONIKGEHÄUSE, SCHARNIERVORRICHTUNG, SCHWENKBARE ELEKTRONIKVORRICHTUNG, GEHÄUSEBAUGRUPPE UND KLIMATISIERUNGSEINHEIT**

(30) Priorität: 14.03.2025 DE 102025109850
(71) Anmelder: Viessmann Holding International GmbH, 35108 Allendorf (Eder) (DE)
(72) Erfinder: FEUSSNER, Yannick, 35099 Burgwald (DE)
(74) Vertreter: MERH-IP Matias Erny Reichl Hoffmann Patentanwälte PartG mbB

(57) **Zusammenfassung**

Die Erfindung stellt ein Elektronikgehäuse 100 zur Aufnahme von elektrischen Leiterplatten 400 bereit, der ein Gehäuse 101 mit einem Aufnahmeraum 102 und eine kabelführende Schwenkvorrichtung 200 zur Befestigung an einem Trägerkörper umfasst, die eine Schwenkbewegung des Gehäuses 101 erlaubt, wenn das Elektronikgehäuse 100 am Trägerkörper befestigt ist, wobei die kabelführende Schwenkvorrichtung 200 eingerichtet ist, einen Abschnitt eines aus einer Umgebung des Gehäuses 101 in den Aufnahmeraum 102 verlaufenden Kabels 401 zu führen und dazu einen Kabelbefestigungsabschnitt 201 umfasst. Der Kabelbefestigungsabschnitt 201 umfasst eine konkave Auflagefläche 202, auf der der Abschnitt des Kabels 401 aufliegen kann, und einen unterhalb der Auflagefläche 202 liegenden Halteabschnitt 203 aufweist, an dem ein Befestigungsmittel 204 angreifen kann, um den auf der Auflagefläche 202 aufliegenden Abschnitt des Kabels 401 an der Schwenkvorrichtung 200 zu befestigen.

## Beschreibung

### Technisches Gebiet

Die vorliegende Erfindung betrifft ein schwenkbares Elektronikgehäuse, eine Schwenkvorrichtung, eine schwenkbare Elektronikvorrichtung, eine Gehäusebaugruppe für eine Klimatisierungseinheit und eine Klimatisierungseinheit.

### Hintergrund der Erfindung

In jüngster Zeit kommen vermehrt vor allem in Privathaushalten Klimatisierungsanlagen zum Einsatz, über die eine Raumklimatisierung und/oder eine Versorgung mit temperiertem Brauchwasser umgesetzt wird.

Als Beispiel für eine solche Klimatisierungsanlage sei eine Wärmepumpenanlage oder eine Klimaanlage genannt, bei denen es sich um thermodynamische Anlagen handelt, mit denen verschiedene Umgebungsenergiequellen, beispielsweise durch Aerothermie, Geothermie oder Hydrothermie, für eine Raumklimatisierung und/oder zum Temperieren von Brauchwasser nutzbar gemacht werden können.

Hierzu wird die Klimatisierungsanlage als eine Art Schnittstelle genutzt, um einen Energie- bzw. Wärmefluss zwischen besagter Umgebungsenergiequelle und einem oder mehreren Zielsystem(en) zu bewirken, bei denen es sich beispielsweise um einen Heizungs-, Lüftungs- oder Brauchwasserkreislauf handeln kann.

Je nach Richtung des Wärmeflusses kann dem Zielsystem so thermische Energie (Wärmeenergie) zugeführt oder entzogen werden, beispielsweise um eine Temperatur eines Energietransportmediums eines Heizungskreislaufs entweder zu erhöhen oder abzusenken, um damit letztlich Räume heizen oder kühlen zu können.

Insbesondere im Falle einer Wärmepumpenanlage umfasst diese üblicherweise eine oder mehrere miteinander verbundene Einheiten, sog. Wärmepumpeneinheiten, wobei zumindest eine dieser Einheiten üblicherweise einen geschlossenen thermodynamischen Arbeitskreislauf (oft auch Kältekreis oder Kältemittelkreislauf genannt) für ein Arbeitsmedium (oft auch Kältemittel genannt) oder zumindest einen Teil davon umfasst. Im Kältekreis wird bei Betrieb der Wärmepumpenanlage Wärmeenergie über einen Wärmeübertrager auf das Kältemittel an einer ersten Stelle übertragen und an zumindest einer weiteren Stelle im Kältekreis wird dem Kältemittel über einen weiteren Wärmeübertrager Wärmeenergie entzogen, um so einen Wärmefluss in das oder aus dem Zielsystem umzusetzen. Die diesbezüglichen technischen Hintergründe sind hinlänglich bekannt.

Im Falle einer Ausführung mit lediglich einer Einheit kann es sich beispielsweise um eine Innen aufgestellte Wärmepumpeneinheit mit integriertem Kältekreis handeln.

Bei mehreren Einheiten kann es sich beispielsweise um eine Ausführung mit einer Innen- und einer Außeneinheit handeln. Der Kältekreis kann hierbei als Teil der Inneneinheit oder als Teil der Außeneinheit ausgeführt sein. Ebenso kann der Kältekreis gemäß eines Split-Prinzips auch aufgetrennt sein, sodass sowohl die Inneneinheit als auch die Außeneinheit jeweils einen Teil des Kältekreises umfassen.

Eine ist dabei üblicherweise für einen innerhalb eines Gebäudes liegenden Aufstellort konzipiert und ist in der Regel mit einer Außeneinheit verbunden, sofern diese vorhanden ist. Die Außeneinheit kann dabei als Wärmequelleneinheit fungieren, über die Wärmeenergie aus einer Umgebungsenergiequelle gewonnen oder an diese abgegeben werden kann.

Ähnliche Ausführungen finden sich auch bei Klimaanlagen, die üblicherweise zur Kühlung eines Lüftungsstroms eingesetzt werden und sich beispielsweise ebenfalls aus einer Innen- und einer Außeneinheit zusammensetzen können.

Da insbesondere Endnutzer ein hohes Maß an Komfort und Steueroptionen erwarten, sind überdies vielfältige Steuermöglichkeiten durch den Nutzer vorgesehen. Beispielhaft sei hier eine App-Steuerung und die Einbindung in ein Smart-Home System genannt. Diese Funktionen müssen allesamt und ungeachtet ihrer konkreten Ausprägung durch entsprechende Steuerelektronik gestützt sein.

Regelmäßig finden sich in einem Gehäuse einer Klimatisierungseinheit also unterschiedliche elektrische Einheiten, wie Leiterplatinen, integrierte Schaltkreise und/oder Schaltungen, die verschiedene elektrische Bauelemente enthalten. Insbesondere ist es dabei üblich elektrische Baugruppen in einem Gehäuse unterzubringen, die sich zweckgemäß in ihrer Spannung unterscheiden.

So kommen üblicherweise sowohl leistungselektronische Baugruppen, als auch Baugruppen zur Steuerung zum Einsatz. Insbesondere können im selben Gehäuse auch Baugruppen unterschiedlicher Spannung, beispielsweise Baugruppen mit einer Spannung von 400 V oder 230 V und Baugruppen mit niedrigerer Spannung wie 12 V oder 24 V untergebracht sein.

Um in diesen Fällen einen sicheren Betrieb zu garantieren, ist es üblich die elektromagnetische Verträglichkeit (EMV) der eingesetzten Baugruppen und -Elemente zu betrachten und zu optimieren.

Besonders die Positionierung von Baugruppen, wie bestückten elektrischen Leiterplatten zueinander, wie auch die Positionierung von elektrischen Leiterplatten, die zu Steuerzwecken eingesetzt werden, zu leistungselektronischen Bauteilen oder Motoren, spielt hierbei eine wichtige Rolle.

Hierbei ist jedoch zu beachten, dass der zur Verfügung stehende Platz begrenzt ist, und entsprechende Baugruppen und -Elemente nicht beliebig weit voneinander entfernt werden können.

Um trotz des eingeschränkten Bauraumes im Inneren eines Gehäuses eine gute EMV zu erreichen, werden üblicherweise Schaltkästen eingesetzt, in denen elektrische Leiterplatten montiert werden können.

Da der Bauraum innerhalb von Gehäusen oft in hohem Maße ausgenutzt wird, gestaltet sich der Einbau von diesen Schaltkästen jedoch schwierig und der Zugang für Wartungen oder Ähnliches ist oft umständlich.

### Zusammenfassung

Eine Aufgabe der vorliegenden Erfindung ist es, ein verbessertes Montagekonzept für elektronische Baugruppen, insbesondere elektrische Leiterplatten mit angeschlossenen Kabeln bereitzustellen, das eine effiziente Montage und Wartung bei hoher EMV ermöglicht.

Zur Lösung dieser Aufgabe werden das schwenkbare Elektronikgehäuse nach Anspruch 1, die Schwenkvorrichtung nach Anspruch 12, die schwenkbare Elektronikvorrichtung nach Anspruch 13, die Gehäusebaugruppe nach Anspruch 14 sowie die Klimatisierungseinheit nach Anspruch 15 bereitgestellt.

Die jeweiligen abhängigen Ansprüche beziehen sich dabei auf bevorzugte Ausführungsformen, die jeweils für sich genommen oder in Kombination bereitgestellt werden können.

Gemäß einem ersten Aspekt wird ein schwenkbares Elektronikgehäuse zur Aufnahme von elektrischen Leiterplatten bereitgestellt. Das Elektronikgehäuse umfasst dabei ein Gehäuse, das einen Aufnahmeraum umgibt, in dem zumindest eine elektrische Leiterplatte aufgenommen werden kann; und zumindest eine Schwenkvorrichtung zur Befestigung des Gehäuses an einem Trägerkörper. Die Schwenkvorrichtung erlaubt dabei, in einem am Trägerkörper befestigten Zustand, zumindest eine Schwenkbewegung des Gehäuses relativ zum Trägerkörper. Bei der Schwenkvorrichtung handelt es sich um eine kabelführende Schwenkvorrichtung, die ausgelegt ist, einen Abschnitt eines aus einer Umgebung des Gehäuses in den Aufnahmeraum verlaufenden Kabels zu führen. Die kabelführende Schwenkvorrichtung umfasst zumindest einen Kabelbefestigungsabschnitt, der eine konkave Auflagefläche, auf der der geführte Abschnitt des Kabels aufliegen kann, aufweist. Weiterhin weist der Kabelbefestigungsabschnitt einen unterhalb der Auflagefläche liegenden Halteabschnitt auf, an dem ein Befestigungsmittel angreifen kann, um den auf der Auflagefläche aufliegenden Abschnitt des Kabels an der Schwenkvorrichtung zu befestigen.

Dadurch wird ein Elektronikgehäuse bereitgestellt, das eine effiziente und flexible Montage von elektrischen Leiterplatten ermöglicht. Die kabelführende Schwenkvorrichtung ermöglicht dabei eine flexible und einfache Montage des Elektronikgehäuses und erleichtert zugleich die Wartung.

Das Gehäuse des Elektronikgehäuses ist dabei nicht näher eingeschränkt und kann insbesondere als Kunststoffgehäuse oder Metallgehäuse, insbesondere mit Isolationsschicht ausgebildet sein.

Weiterhin ist der Aufnahmeraum des Gehäuses als nicht näher beschränkt zu verstehen.

Als Trägerkörper ist jedweder Körper zu verstehen, an dem das Elektronikgehäuse befestigt werden kann. Beispielhaft und nicht abschließend kann es sich um einen Aufnahmerahmen, ein Gehäuse, auch einen speziellen Bereich eines Gehäuses oder eine Wand handeln.

Vorzugsweise handelt es sich bei der Schwenkvorrichtung um eine Scharniervorrichtung.

Vorteilhaft umfasst der Aufnahmeraum zur Aufnahme zumindest einer elektrischen Leiterplatte zusätzlich wenigstens eine geeignete Aufnahmevorrichtung. Insbesondere kann es sich bei der Aufnahmevorrichtung um Stützen handeln, an denen eine aufzunehmende Leiterplatte befestigt wird. Weiterhin kann die elektrische Leiterplatte beispielsweise auch durch eine entsprechende Steck- oder Klemmverbindung in den Aufnahmeraum aufgenommen werden.

Dadurch kann eine elektrische Leiterplatte besonders einfach und schnell, insbesondere ohne die Notwendigkeit eines Werkzeugeinsatzes, im Aufnahmeraum aufgenommen werden.

Vorteilhaft umgibt das Gehäuse den Aufnahmeraum nicht komplett. Beispielsweise kann das Gehäuse auch Aussparungen, Löcher oder Schlitze, insbesondere zu Belüftungszwecken, aufweisen. Diese können entsprechend einer Position der elektrischen Leiterplatte im Aufnahmeraum angeordnet sein.

Diese Ausführung erlaubt eine bessere Kühlung der aufgenommenen elektrischen Leiterplatte und/oder von elektrischen Komponenten, die auf dieser montiert sind.

Vorteilhaft umfasst die zumindest eine Schwenkvorrichtung des Elektronikgehäuses wenigstens zwei getrennte Schwenkelemente. Insbesondere sind diese nicht auf eine bestimmte Ausführungsart festgelegt.

Diese Ausführung erlaubt eine leichtere Montage, da die Ausrichtung einer großen Schwenkvorrichtung bei der Montage entfällt.

Der Kabelbefestigungsabschnitt mit der konkaven Auflagefläche ist vorteilhaft integral mit der Schwenkvorrichtung ausgebildet.

Hierdurch wird die Montage weiter erleichtert, da auf zusätzliche Bauteile verzichtet werden kann. Zusätzlich wird in dieser Ausführungsform eine höhere Stabilität des Kabelbefestigungsabschnitts erreicht.

Die konkave Form der Auflagefläche erlaubt es, Kabel unterschiedlicher Durchmesser am Kabelbefestigungsabschnitt zu befestigen, ohne dass Kabel größeren Durchmessers zu stark gequetscht werden, oder Kabel kleineren Durchmessers unzureichend befestigt werden.

In einer anderen vorteilhaften Ausführungsform ist der Kabelbefestigungsabschnitt als weiteres Bauteil gefertigt, welches mit der Schwenkvorrichtung verbunden wird.

Auf diese Weise kann je nach Zugang zur Schwenkvorrichtung eine leichtere Befestigung von Kabeln erreicht werden. Ist der Zugang beispielsweise erschwert, kann ein Kabel bereits vor der endgültigen Montage mit dem Kabelbefestigungsabschnitt verbunden werden, bevor dieser in einem zweiten Schritt an der Schwenkvorrichtung befestigt wird.

Hierzu können die Schwenkvorrichtung und der Kabelbefestigungsabschnitt vorteilhaft einen Verbindungsabschnitt zum Herstellen einer formschlüssigen Verbindung, insbesondere einer Steckverbindung, aufweisen.

In einer vorteilhaften Ausführungsform des Elektronikgehäuses ist der unterhalb der Auflagefläche liegende Halteabschnitt als nutförmige Ausformung integral mit der Schwenkvorrichtung ausgeführt.

Insbesondere bildet die nutförmige Ausformung bei einer Verbindung der Schwenkvorrichtung mit dem Trägerkörper eine Durchführung mit einer Oberfläche desselben.

In anderen Worten liegt die Schwenkvorrichtung bei einer Verbindung mit dem Trägerkörper derart auf demselben auf, dass eine Durchführung, insbesondere für ein Befestigungsmittel, gebildet wird, deren Umfang auf einer Seite durch eine Oberfläche des Trägerkörpers begrenzt ist und auf den anderen Seiten durch die nutförmige Ausformung der Schwenkvorrichtung begrenzt ist.

Dadurch werden insbesondere Wartungsarbeiten erleichtert, da Befestigungsmittel angebracht beziehungsweise entfernt werden können, ohne dass die Schwenkvorrichtung und/oder des Elektronikgehäuses insgesamt demontiert werden müssen. Es lassen sich somit Kabel lediglich durch das Hinzufügen oder Entfernen von Befestigungsmitteln an dem Kabelbefestigungsabschnitt befestigen oder von diesem entfernen. Somit wird beispielsweise ein Kabeltausch wesentlich beschleunigt, ohne auf die Sicherheit einer Kabelbefestigung zu verzichten.

In einer weiteren vorteilhaften Ausführungsform weist der Halteabschnitt wenigstens ein Gewinde auf.

Auf diese Weise kann ein Befestigungsmittel, wie beispielsweise eine Schelle mittels einer Schraube, die in das Gewinde des Halteabschnitts eingreift, Kabel auf der Auflagefläche fixieren und somit am Kabelbefestigungsabschnitt befestigen.

Befestigungsmittel ist als nicht näher eingeschränkt zu verstehen. Insbesondere können Befestigungsmittel wie (Gummi- oder Klett-)Bänder, Klemmen, Klebstoffe, Klammern, Schellen oder Kabelbinder zum Einsatz kommen, um Kabel am Kabelbefestigungsabschnitt zu befestigen.

Der Kabelbefestigungsabschnitt erlaubt es, einen Abschnitt eines Kabels aus einer Umgebung des Gehäuses in den Aufnahmeraum zu führen.

Vorteilhaft ist der Kabelbefestigungsabschnitt dazu eingerichtet, eine Zugentlastung für an demselben befestigten Kabel bereitzustellen.

Dazu ist der Kabelbefestigungsabschnitt beispielsweise entsprechend groß dimensioniert und/oder weist eine Geometrie auf, die eine Aufnahme von Zugkräften erlaubt.

Der Kabelbefestigungsabschnitt an der Schwenkvorrichtung ermöglicht es, das Elektronikgehäuse besonders flexibel einzusetzen. So lassen sich beispielsweise bei der Befestigung von Kabeln entsprechende Überlängen vorsehen, die dann bereitstehen, wenn das Elektronikgehäuse geschwenkt wird. Auf diese Weise wird vermieden, dass sich Kabelverbindungen beim Schwenken des Elektronikgehäuses lösen oder sogar durch den Schwenkvorgang beschädigt werden.

Das Elektronikgehäuse kann somit vorteilhaft auch in Positionen montiert werden, die zwar einerseits, beispielsweise aufgrund von EMV und/oder zur örtlichen Trennung von Netzspannung und Kleinspannung gewünscht sind, aber andererseits, beispielsweise aufgrund von Zugänglichkeit in einen Innenraum des Trägerkörpers, unerwünscht sind, da das Elektronikgehäuse durch den Kabelbefestigungsabschnitt auch sehr häufig geschwenkt werden kann, ohne dass eine Unterbrechung der Verbindung von befestigten Kabeln befürchtet werden muss.

Weiterhin erlaubt der Kabelbefestigungsabschnitt unterschiedliche Kabel in unterschiedliche Richtungen in der Umgebung des Elektronikgehäuses zu führen.

Dadurch lässt sich das Elektronikgehäuse besonders vorteilhaft für komplexe Einsatzszenarien verwenden, die neben dem Elektronikgehäuse mit den aufgenommenen elektrischen Leiterplatten, mehrere andere elektrische Baugruppen aufweisen. Unterschiedliche Kabel können bereits in die benötigten Richtungen ausgehend vom Elektronikgehäuse geleitet werden, indem sie entsprechend am Kabelbefestigungsabschnitt befestigt werden.

Das Elektronikgehäuse inklusive der darin aufgenommenen elektrischen Leiterplatten mit angeschlossenen Kabeln lässt sich so vorteilhaft als einzelne Einheit betrachten, vorbereiten und montieren, wodurch er besonders effizient eingesetzt werden kann.

In einer bevorzugten Ausführungsform umfasst die Schwenkvorrichtung einen Befestigungsschnittstellenabschnitt, der derart auf einen Aufnahmeabschnitt des Trägerkörpers angepasst ist, dass die Schwenkvorrichtung am Trägerkörper form- und/oder kraftschlüssig befestigt ist, wenn der Befestigungsschnittstellenabschnitt und der Aufnahmeabschnitt in Wechselwirkung gebracht sind.

Auf diese Weise lässt sich das Elektronikgehäuse noch effizienter montieren, da der Befestigungsschnittstellenabschnitt und der Aufnahmeabschnitt am Trägerkörper insbesondere ohne Werkzeug in Wechselwirkung gebracht werden können.

In einer vorteilhaften Ausführungsform sind der Befestigungsschnittstellenabschnitt und der Aufnahmeabschnitt am Trägerkörper zerstörungsfrei voneinander lösbar, was beispielsweise einen Austausch von Teilen des Elektronikgehäuses erleichtert.

Besonders eine Wartung von im Elektronikgehäuse aufgenommenen elektrischen Leiterplatten wird dadurch erleichtert, da das Elektronikgehäuse als Ganzes vom Trägerkörper entfernt werden kann, wodurch die Wartung beispielsweise in einer günstigeren Position, wie an einem Tisch sitzend, statt vor dem Elektronikgehäuse stehend, erfolgen kann.

In einer weiteren bevorzugten Ausführungsform sind der Befestigungsschnittstellenabschnitt und der Aufnahmeabschnitt derart ausgestaltet, dass diese durch elastische Verformung des Befestigungsschnittstellenabschnitts und/oder des Aufnahmeabschnitts voneinander lösbar sind.

In einer besonders bevorzugten Ausführung sind der Befestigungsschnittstellenabschnitt und der Aufnahmeabschnitt als Einrastmechanismus ausgeführt, bei dem ein elastischer Rast- oder Hakenabschnitt in eine auf diesen angepasste Rast- bzw. Hakenöffnung eingreift, wenn der Befestigungsschnittstellenabschnitt und der Aufnahmeabschnitt in Wechselwirkung gebracht sind.

Besonders vorteilhaft umfasst der Rast- oder Hakenabschnitt hierzu wenigstens zwei elastische Haken und der Trägerkörper entsprechend wenigstens zwei Rast- bzw. Hakenöffnungen, um auf diese Weise eine sichere Verbindung von Schwenkvorrichtung und Trägerkörper zu garantieren.

In einer bevorzugten Ausführungsform weist der zumindest eine Kabelbefestigungsabschnitt der Schwenkvorrichtung einen Ausrichtabschnitt zur Führung und/oder Ausrichtung des Befestigungsmittels auf, der das Befestigungsmittel bei einer Bewegung des Befestigungsmittels relativ zum Halteabschnitt führt und/oder gegenüber dem Halteabschnitt ausrichtet, wenn das Befestigungsmittel in Wechselwirkung mit dem Ausrichtabschnitt gebracht ist.

In einer weiter bevorzugten Ausführungsform ist der Halteabschnitt nutförmig ausgebildet und der Ausrichtabschnitt ist vorzugsweise durch einen an einem Ende des Halteabschnitts befindlichen bogenförmigen Umlenkabschnitt gebildet, an dem ein durch den Halteabschnitt geführtes Befestigungsmittel umgelenkt wird, vorzugsweise stehen die Enden des Umlenkabschnitts in einem Winkel von 50° bis 130° zueinander, besonders bevorzugt in einem Winkel von 70° bis 100°.

Die genannten Winkelbereiche sind dabei im Hinblick auf zu erwartende Befestigungsmittel vorteilhaft gewählt, um ein Knicken oder Brechen unterschiedlich dimensionierter Befestigungsmittel zu erschweren.

Insbesondere bei Kabelbindern ist dabei zu erwägen, mit welcher Dicke diese ausgeführt sind, da sich die Dicke der einzusetzenden Kabelbinder direkt auf einen minimalen Winkel der Enden des Umlenkabschnitts zueinander auswirkt. Selbst wenn eine Beschädigung der Kabelbinder nicht zu erwarten ist, kann ein zu klein gewählter Winkel zu einer erschwerten Handhabung, bis zu einem Steckenbleiben umzulenkender Kabelbinder, führen.

Vorteilhaft richtet der Ausrichtabschnitt ein Befestigungsmittel, welches in einer Richtung im Wesentlichen parallel zur Haupterstreckungsrichtung des nutförmigen Halteabschnitts durch denselben geführt wird, derart aus, dass das Befestigungsmittel den Ausrichtabschnitt in einer Richtung im Wesentlichen senkrecht zur Haupterstreckungsrichtung des Halteabschnitts verlässt. Das erleichtert insbesondere einen Zugang zum ausgerichteten Ende des Befestigungsmittels und beschleunigt so dessen Einsatz.

In einer besonders vorteilhaften Ausführungsform befindet sich ein solcher bogenförmiger Umlenkabschnitt an beiden Seiten des nutförmigen Halteabschnitts. Auf diese Weise kann ein Befestigungsmittel bereits in einer Richtung im Wesentlichen senkrecht zur Haupterstreckungsrichtung des Halteabschnitts eingeführt werden, wobei es durch den ersten Umlenkabschnitt derart umgelenkt wird, dass es durch den nutförmigen Halteabschnitt geführt wird. Beim weiteren Durchführen des Befestigungsmittels, wird dessen durchgeführtes Ende dann erneut durch den zweiten Umlenkabschnitt umgelenkt und verlässt den Halteabschnitt somit im Wesentlichen parallel zum eingeführten Ende. Dadurch wird die Handhabung des Befestigungsmittels weiter erleichtert, was dessen Einsatz erneut beschleunigt und so die Effizienz steigert.

Besonders vorteilhaft lässt sich auf diese Weise ein wenigstens teilweise flexibles Befestigungsmittel, insbesondere ein Kabelbinder, verwenden, um Kabel am Kabelbefestigungsabschnitt der Schwenkvorrichtung zu befestigen. Besonders falls das Elektronikgehäuse in einem unzugänglichen Bereich verbaut wurde, ist das Befestigen von Kabeln durch den Ausrichtabschnitt wesentlich erleichtert.

Insbesondere verhindert der Ausrichtabschnitt durch seine Form vorteilhaft, dass der Kabelbinder stecken bleibt oder anstößt.

In einer vorteilhaften Ausführungsform ist der Ausrichtabschnitt zusätzlich eingerichtet, ein komplettes Durchführen eines Befestigungselements zu verhindern.

Beispielsweise ist der Ausrichtabschnitt derart dimensioniert, dass das Kopfende eines Kabelbinders nicht durchgeführt werden kann. Auf diese Weise kann die Befestigung von Kabeln am Kabelbefestigungsabschnitt der Schwenkvorrichtung mittels eines Kabelbinders einhändig erfolgen, was besonders bei schlecht zugänglichen und schlecht beleuchteten Schaltkästen vorteilhaft ist.

In einer weiteren bevorzugten Ausführungsform ist die Schwenkvorrichtung mehrteilig ausgeführt und umfasst zumindest einen trägerkörperseitigen Teil und einen gehäuseseitigen Teil, die gegeneinander schwenkbar sind und die miteinander über ein Verbindungsmittel lösbar verbunden sind, wobei vorzugsweise der trägerkörperseitige Teil den zumindest einen Kabelbefestigungsabschnitt aufweist.

Die (De-)Montage des Elektronikgehäuses dieser Ausführungsform ist besonders effizient. So lässt sich das Gehäuse des Elektronikgehäuses als Ganzes vom Trägerkörper entnehmen oder mit diesem Verbinden, ohne dass die Schwenkvorrichtung selbst vom Trägerkörper entfernt oder mit diesem verbunden werden muss.

Das erlaubt beispielsweise ein einfaches Tauschen der elektrischen Leiterplatten, die im Elektronikgehäuse montiert sind, ohne dass an der Schwenkvorrichtung befestigte Kabel gelöst werden müssen. Es müssen lediglich alle Kabel von den elektrischen Leiterplatten im Elektronikgehäuse getrennt werden. Anschließend kann das Verbindungsmittel entfernt und das Elektronikgehäuse inklusive aller in ihm aufgenommenen Leiterplatten entfernt werden.

Als Verbindungsmittel sind hier alle Mittel zu verstehen, die eine lösbare Verbindung des Gehäuses mit der Schwenkvorrichtung ermöglichen. Beispielsweise und nicht abschließend kann es sich bei dem Verbindungsmittel um Schrauben oder Bolzen handeln.

Diese Ausführungsform erlaubt zusätzlich, dass vorgesehene Kabel am Kabelbefestigungsabschnitt einer bereits unabhängig vom Elektronikgehäuse montierten Schwenkvorrichtung montiert werden können, was die Montageeffizienz besonders steigert.

Weiterhin können Kabel auch bereits so befestigt werden, dass sie entsprechend einer späteren Anschlussposition mit Montagelänge ausgestattet und ausgerichtet sind. Dieses Vorgehen vermeidet Montagefehler durch falsche Kabelverbindungen und steigert somit erneut die Effizienz und Sicherheit.

Bei einer weiteren bevorzugten Ausführungsform umfasst die Schwenkvorrichtung zusätzlich eine Positionierungshilfe, mittels der die Schwenkvorrichtung in einer Verbindungsposition an und/oder im Trägerkörper positioniert werden kann.

Als Positionierungshilfe sind jegliche optische und/oder haptische Mittel zu verstehen, die es erlauben, die Schwenkvorrichtung in einer Verbindungsposition an und/oder im Trägerkörper zu positionieren. Insbesondere und nicht abschließend kann es sich bei einer Positionierungshilfe um Aussparungen in der Schwenkvorrichtung, aufgedruckte oder eingebrachte Markierungen der Schwenkvorrichtung oder Ausformungen der Schwenkvorrichtung handeln, die Flächen, Kanten und/oder Ausformungen des Trägerkörpers kontaktieren und/oder in diese eingreifen.

Vorteilhaft ist die Positionierungshilfe der Schwenkvorrichtung als Menge von Ausformung ausgebildet, die in der Verbindungsposition in entsprechende Aussparungen des Trägerkörpers eingreifen. Auf diese Weise kann die Schwenkvorrichtung schnell und kontrollierbar in die Verbindungsposition gebracht werden, wodurch eine Montageeffizienz der Schwenkvorrichtung gesteigert wird.

In einer zusätzlichen bevorzugten Ausführungsform umfasst die Schwenkvorrichtung einen oder mehrere weitere Kabelbefestigungsabschnitte, die jeweils eine konkave Auflagefläche, auf der der Abschnitt des Kabels aufliegen kann, und einen unterhalb der Auflagefläche liegenden Halteabschnitt aufweisen, an dem ein Befestigungsmittel angreifen kann, um den auf der Auflagefläche aufliegenden Abschnitt des Kabels an der Schwenkvorrichtung zu befestigen.

Die dadurch eröffneten zusätzlichen Möglichkeiten, Kabel an der Schwenkvorrichtung zu befestigen, steigern weiter die Flexibilität, wie Kabel aus dem oder in das Elektronikgehäuse geführt werden können.

In einer weiteren bevorzugten Ausführungsform sind der zumindest eine Kabelbefestigungsabschnitt und der eine oder die mehreren weiteren Kabelbefestigungsabschnitte symmetrisch angeordnet.

Besonders vorteilhaft ist die Schwenkvorrichtung insgesamt symmetrisch ausgebildet.

Auf diese Weise kann die Schwenkvorrichtung sehr vielseitig mit dem Trägerkörper verbunden werden. Insbesondere wird so eine Verbindung beispielsweise auf zwei einander gegenüberliegenden Seiten eines Eingriffsbereichs im Trägerkörper ermöglicht.

Besonders vorteilhaft werden durch diese Ausführung auch flexible Umbauten ermöglicht. Beispielsweise kann das Elektronikgehäuse je nach Gegebenheiten eines Raumes, in dem der Trägerkörper aufgestellt ist, mit demselben verbunden werden. Ist es beispielsweise im Aufstellraum nicht möglich, dass das Elektronikgehäuse auf eine rechte Seite relativ zum Trägerkörper geschwenkt werden kann, erlaubt die spiegelsymmetrisch ausgeführte Schwenkvorrichtung eine Verbindung derart, dass das Elektronikgehäuse auf eine linke Seite relativ zum Trägerkörper geschwenkt werden kann, was die Einsatzflexibilität des Elektronikgehäuses steigert.

In einer weiteren bevorzugten Ausführungsform, umfasst das Elektronikgehäuse eine oder mehrere weitere Schwenkvorrichtungen.

So können auch Schaltschrankgehäuse mit sich stark unterscheidenden Größen zum Einsatz kommen, da die Anzahl und Position der Schwenkvorrichtungen relativ zum Gehäuse des Schaltschranks einfach geändert werden können.

Weiter vorteilhaft kann die Organisation der an den Schwenkvorrichtungen befestigten Kabel weiter verbessert werden. Beispielsweise können Kabel, die in das Gehäuse des Elektronikgehäuses geleitet werden, je nach Spannung die sie führen, an der einen oder an der anderen Schwenkvorrichtung befestigt werden. Auch eine Trennung nach Signaltyp und/oder nach Spannung ist von Vorteil.

Gemäß einem weiteren Aspekt der Erfindung wird eine Schwenkvorrichtung eines Elektronikgehäuses bereitgestellt, die wie vorstehend im Zusammenhang mit dem Elektronikgehäuse zum Einsatz kommt.

Insbesondere ist die Schwenkvorrichtung derart eingerichtet, dass über diese ein Schwenkkörper, beispielsweise das Gehäuse des Elektronikgehäuses, gegenüber einem Trägerkörper schwenkbar ist, wenn die Schwenkvorrichtung am Schwenkkörper und am Trägerkörper befestigt ist. Die Schwenkvorrichtung ist eine kabelführende Schwenkvorrichtung, die ausgelegt ist, einen Abschnitt eines Kabels, das von einer Trägerkörper-seitigen Umgebung in eine Schwenkkörper-seitige Umgebung verläuft, zu führen. Die kabelführende Schwenkvorrichtung umfasst zumindest einen Kabelbefestigungsabschnitt, der eine konkave Auflagefläche, auf der der Abschnitt des Kabels aufliegen kann, und einen unterhalb der Auflagefläche liegenden Halteabschnitt aufweist, an dem ein Befestigungsmittel angreifen kann, um den auf der Auflagefläche aufliegenden Abschnitt des Kabels an der Schwenkvorrichtung zu befestigen.

Gemäß einem weiteren Aspekt der Erfindung wird eine schwenkbare Elektronikvorrichtung bereitgestellt, die ein Elektronikgehäuse, wie vorstehend beschrieben, sowie zumindest eine elektrische Leiterplatte, die im Aufnahmeraum des Elektronikgehäuses aufgenommen und insbesondere dort befestigt ist.

Gemäß einem weiteren Aspekt der Erfindung wird eine Gehäusebaugruppe zum Einsatz in einer Klimatisierungseinheit bereitgestellt. Die Gehäusebaugruppe umfasst dabei ein oder mehrere Gehäuseelemente, die zusammen einen Innenraum definieren und ein Elektronikgehäuse, wie vorstehend beschrieben. Das Elektronikgehäuse ist dabei über seine Schwenkvorrichtung an einem der ein oder mehreren Gehäuseelemente, welches als Trägerkörper fungiert, schwenkbar befestigt.

Vorzugsweise ist das Elektronikgehäuse derart befestigt, dass es sich zumindest in einer ersten Schwenkstellung ganz oder teilweise im Innenraum befindet.

Auf diese Weise kann die Gehäusebaugruppe vorteilhaft platzsparend dimensioniert sein, da die benötigte Elektronik, insbesondere die elektrischen Leiterplatten im Elektronikgehäuse im Innenraum untergebracht sein kann.

Anders gesagt, weist die Gehäusebaugruppe mit dem Elektronikgehäuse einen dedizierten Ort auf, an dem elektrische Leiterplatten untergebracht werden können. Da das Elektronikgehäuse wie vorstehend beschrieben sehr flexibel positioniert werden kann, ist zusätzlich die Möglichkeit gegeben die elektrischen Leiterplatten im Hinblick auf EMV vorteilhaft in der Gehäusebaugruppe zu platzieren, indem das Elektronikgehäuse passend mittels der Schwenkvorrichtung an einem Gehäuseelement befestigt wird.

Weiter vorteilhaft können dabei Aspekte wie die Zugänglichkeit des Innenraums im Hinblick auf eine EMV-günstige Positionierung der Leiterplatten außer Acht gelassen werden, da das Elektronikgehäuse aufgrund seiner Schwenkbarkeit an eine andere Position, z. B. eine Serviceposition, geschwenkt werden kann.

In einer vorteilhaften Ausführungsform der Gehäusebaugruppe, ist das Elektronikgehäuse dabei so positioniert, dass es zumindest in eine Wartungsposition geschwenkt werden kann, in der es aus dem Innenraum herausragt.

Dadurch versperrt das Elektronikgehäuse den Zugang zum Innenraum nicht, falls dieser benötigt wird. Wird der Zugang nicht benötigt, kann das Elektronikgehäuse wieder in den Innenraum geschwenkt werden. Somit kann eine optimale Nutzung des begrenzten Platzes im Innenraum sichergestellt werden.

Die Schwenkvorrichtung des Elektronikgehäuses erlaubt es dabei die Position des Elektronikgehäuses zu ändern und an den konkreten Einsatzfall anzupassen.

Gemäß einem weiteren Aspekt der Erfindung wird eine Klimatisierungseinheit bereitgestellt, die eine Gehäusebaugruppe, wie vorstehend beschrieben, zumindest eine elektrische Leiterplatte, die im Aufnahmeraum des Elektronikgehäuses aufgenommen ist, und zumindest ein Kabel umfasst. Das Kabel ist dabei an der zumindest einen Leiterplatte angeschlossen, über die kabelführende Schwenkvorrichtung aus dem Aufnahmeraum herausgeführt, liegt auf der Auflagefläche auf und ist mittels eines am Halteabschnitt angreifenden Befestigungsmittels an der Schwenkvorrichtung befestigt.

Dadurch wird eine effiziente Montage der unterschiedlichen Baugruppen der Klimatisierungseinheit ermöglicht. So lässt sich insbesondere die Verkabelung sehr flexibel vornehmen, da die Kabel bereits frühzeitig an der Schwenkvorrichtung befestigt werden können und zwar ungeachtet der Montagereihenfolge der an die Kabel anzuschließenden Komponenten. Da weiterhin auch benötigte Längen vorab konfektioniert werden können, sind auch Verkabelungsfehler reduziert, was die Sicherheit der Klimatisierungseinheit erhöht.

In einer vorteilhaften Ausführungsform umfasst die Klimatisierungseinheit zwei elektrische Leiterplatten, die im Aufnahmeraum des Elektronikgehäuses aufgenommen sind und zumindest zwei Kabel, wobei an jede der elektrischen Leiterplatten eines der Kabel angeschlossen ist, jedes der Kabel über die kabelführende Schwenkvorrichtung aus dem Aufnahmeraum herausgeführt ist, auf der Auflagefläche aufliegt und mittels eines am Halteabschnitt angreifenden Befestigungsmittels an der Schwenkvorrichtung befestigt ist, derart, dass wenigstens zwei der Kabel in unterschiedliche Richtungen im Innenraum geführt werden.

Dadurch ergibt sich die Möglichkeit, Verkabelungen für unterschiedliche Zwecke bereits frühzeitig getrennt voneinander in der Gehäusebaugruppe zu verlegen. Insbesondere können Kabel unterschiedlicher Spannungsniveaus oder zu unterschiedlichen Steuerungszwecken getrennt voneinander im Gehäuse geführt werden und bereits so in unterschiedliche Richtungen verlaufend an der Schwenkvorrichtung befestigt werden, dass die Gefahr einer falschen Verkabelung an den elektrischen Leiterplatten im Elektronikgehäuse minimiert wird. Dadurch wird die Montageeffizienz und Sicherheit sowohl bei der Montage als auch im Betrieb der Klimatisierungseinheit weiter erhöht.

In einer bevorzugten Ausführungsform umfasst die Klimatisierungseinheit weiter ein oder mehrere Hydraulikkomponenten eines Hydraulikkreislaufs, die teilweise oder ganz im Innenraum angeordnet sind, und/oder einen Kältemittelkreislauf, der teilweise oder ganz im Innenraum angeordnet ist, und/oder Teile eines Kältemittelkreislaufs, der teilweise oder ganz im Innenraum angeordnet ist.

Bei dem Hydraulikkreislauf kann es sich beispielsweise um einen Hydraulikkreislauf zum Transport eines durch die Klimatisierungsanlage temperierten Energietransportmediums, beispielsweise durch eine Temperiervorrichtung, die insbesondere einen Kältemittelkreislauf umfasst, handeln, insbesondere einem Heizungskreislauf zum Heizen von Räumen und/oder zum Erwärmen von Brauchwasser.

Bei der Temperiervorrichtung kann es sich beispielsweise um eine Außeneinheit der Klimatisierungsanlage handeln.

Das temperierte Energietransportmedium kann dann beispielsweise zur Klimatisierung eines Raums eingesetzt werden, in dem dieses zu einem Wärmeübertrager in besagtem Raum geleitet wird, und/oder zur Erwärmung von Brauchwasser eingesetzt werden, in dem dieses zu einem Wärmeübertrager eines Brauchwassersystems geleitet wird.

Hydraulikkomponenten des Hydraulikkreislaufs, die als Teil der Klimatisierungseinheit ausgeführt sind, können hierbei ein oder mehrere aus der folgenden Gruppe sein:
- eine Umwälzpumpe zur Förderung des Energietransportmediums;
- ein Druckspeicher;
- Stell- und/oder Regelungsventile.

Vorzugsweise umfasst die Klimatisierungseinheit Anschlüsse zur Anbindung der Hydraulikkomponenten an den Hydraulikkreislauf. Diese Anschlüsse umfassen vorzugsweise einen oder mehrere der folgenden Anschlüsse:
- einen Heizkreis-Vorlaufanschluss, der an einen Vorlauf eines Heizkreises angeschlossen werden kann,
- einen Heizkreis-Rücklaufanschluss, der an einen Rücklauf eines Heizkreises angeschlossen werden kann;
- einen Brauchwassersystem-Vorlaufanschluss, der an einen Vorlauf eines Brauchwassersystems angeschlossen werden kann;
- einen Brauchwassersystem-Rücklaufanschluss, der an einen Rücklauf eines Brauchwassersystems angeschlossen werden kann;
- einen ersten Temperiervorrichtungsanschluss, der an einen Rücklauf der Temperiervorrichtung angeschlossen werden kann, um dieser zu temperierendes Energietransportmedium zuzuführen;
- einen zweiten Temperiervorrichtungsanschluss, der an einen Vorlauf der Temperiervorrichtung angeschlossen werden kann, um durch die Temperiervorrichtung temperiertes Energietransportmedium zu erhalten.

Vorzugsweise sind die Hydraulikkomponenten der Klimatisierungseinheit dabei derart miteinander verbunden, dass das in den Heizkreis-Rücklaufanschluss und/oder in den Brauchwassersystem-Rücklaufanschluss strömende Energietransportmedium über den ersten Temperiervorrichtungsanschluss zu einer Temperiervorrichtung geleitet werden kann, in der das Energietransportmedium temperiert werden kann. Vorzugsweise sind die Hydraulikkomponenten der Klimatisierungseinheit weiter derart miteinander verbunden, dass das in den zweiten Temperiervorrichtungsanschluss strömende Energietransportmedium über den Heizkreis-Vorlaufanschluss einem Heizkreis und/oder über den Brauchwassersystem-Rücklaufanschluss einem Brauchwassersystem zugeführt werden kann.

Vorzugsweise umfasst der Kältemittelkreislauf die bei einem solchen üblichen Komponenten, namentlich einen ersten Wärmeübertrager und einen zweiten Wärmeübertrager, über die dem Kältemittel jeweils Wärmeenergie zugeführt und/oder entzogen werden kann, eine Verdichtungsvorrichtung zum Verdichten des Kältemittels, und eine Expansionsvorrichtung zum Expandieren des Kältemittels.

Weitere Aspekte und deren Vorteile als auch speziellere Ausführungsbeispiele der zuvor genannten Aspekte und Ausführungsformen werden im Folgenden unter Zuhilfenahme der in den beigefügten Figuren gezeigten Zeichnungen beschrieben.
Fig. 1 zeigt eine Schnittansicht eines vorteilhaften Ausführungsbeispiels des Elektronikgehäuses mit verbundener Schwenkvorrichtung, wobei zwei elektrische Leiterplatten im Aufnahmeraum aufgenommen sind.
Fig. 2 zeigt eine Schnittansicht eines Teils eines Ausführungsbeispiels der Schwenkvorrichtung des Elektronikgehäuses aus Fig. 1.
Fig. 3 zeigt eine Ansicht der Außenseite eines Teils eines vorteilhaften Ausführungsbeispiels der Schwenkvorrichtung.
Fig. 4 zeigt einen Querschnitt eines vorteilhaften Ausführungsbeispiels der Schwenkvorrichtung des Elektronikgehäuses.
Fig. 5 zeigt ein vorteilhaftes Ausführungsbeispiel der Schwenkvorrichtung mit daran befestigten Kabeln.
Fig. 6 zeigt ein vorteilhaftes Ausführungsbeispiel einer Gehäusebaugruppe mit einem Elektronikgehäuse, der in eine Serviceposition geschwenkt ist.
Fig. 7 zeigt eine vorteilhafte Ausführung einer Gehäusebaugruppe mit einem Elektronikgehäuse, der in eine Betriebsposition geschwenkt ist.
Fig. 8 zeigt einen Querschnitt eines vorteilhaften Ausführungsbeispiels der Schwenkvorrichtung mit daran befestigtem Kabel, senkrecht zu einer Haupterstreckungsrichtung des Kabels.
Fig. 9 zeigt einen Querschnitt eines vorteilhaften Ausführungsbeispiels der Schwenkvorrichtung mit daran befestigtem Kabel, parallel zu einer Haupterstreckungsrichtung des Kabels.

Es wird hervorgehoben, dass die vorliegende Erfindung in keiner Weise auf die nachfolgend beschriebenen Ausführungsbeispiele und deren Ausführungsmerkmale begrenzt ist. Die Erfindung umfasst weiterhin Modifikationen der genannten Ausführungsbeispiele, insbesondere diejenigen, die aus Modifikationen und/oder Kombinationen einzelner oder mehrerer Merkmale der beschriebenen Ausführungsbeispiele im Rahmen des Schutzumfanges der unabhängigen Ansprüche hervorgehen.

### Ausführliche Figurenbeschreibung

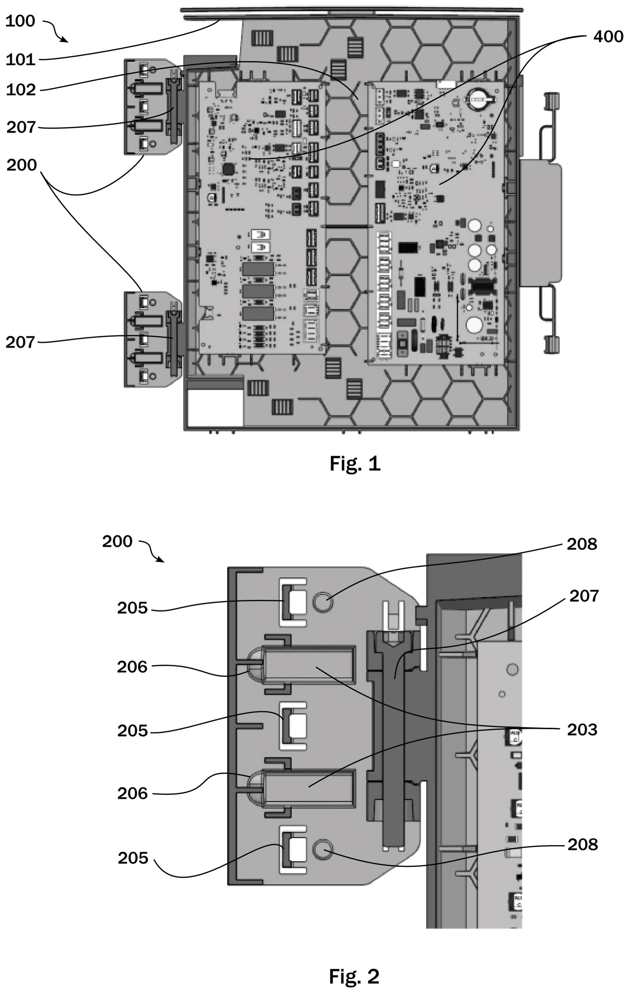

Fig. 1 zeigt ein Schnittbild des Elektronikgehäuses 100 mit verbundener Schwenkvorrichtung 200, wobei zwei elektrische Leiterplatten 400 im Aufnahmeraum 102 des Gehäuses 101 des Elektronikgehäuses aufgenommen sind.

Das Elektronikgehäuse 100 umfasst ein Gehäuse 101 mit einem Aufnahmeraum 102 in dem zwei elektrische Leiterplatten 400 aufgenommen sind. Weiterhin umfasst das Elektronikgehäuse 100 eine Schwenkvorrichtung 200 bzw. beispielhaft zwei Schwenkvorrichtungen 200, die jeweils mit einem Verbindungsmittel 207 mit dem Gehäuse 101 verbunden sind.

Bei dem Ausführungsbeispiel von Fig. 1 handelt es sich bei dem Verbindungsmittel 207 um einen Bolzen, der jeweils entsprechende Bohrungen oder Löcher im Gehäuse 101 und der Schwenkvorrichtung 200, beziehungsweise der einzelnen Elemente der Schwenkvorrichtung 200 durchdringt, die insbesondere eine Scharniervorrichtung ist.

Auf diese Weise kann das Gehäuse 101 des Elektronikgehäuses 100 besonders einfach und lösbar mit der Schwenkvorrichtung 200 verbunden werden, was ein einfaches Einsetzen und Abnehmen des Gehäuses 101 des Elektronikgehäuses 100 ermöglicht, wodurch eine Montage besonders erleichtert wird.

Vorteilhaft kann der Bolzen ganz oder teilweise mit einem Gewinde versehen sein, welches in einen Teil der Schwenkvorrichtung 200 eingreift, um eine sichere Verbindung von Gehäuse 101 und Schwenkvorrichtung 200 zu garantieren.

Die Aufnahme der elektrischen Leiterplatten 400 ist nicht besonders eingeschränkt. Insbesondere können diese in den Aufnahmeraum 102 eingesteckt, geschraubt, geklemmt oder geklebt werden. Die konkrete Art der Aufnahme kann dabei entsprechend dem Einsatzzweck und/oder der Gegebenheiten der Einsatzumgebung ausgewählt werden.

Vorzugweise ist das Gehäuse 101 des Elektronikgehäuses 100 derart ausgeformt, dass ein Eindringen von Tropfwasser verhindert wird.

Die konkrete Art der Ausformung ist dabei nicht näher eingeschränkt. Im Ausführungsbeispiel von Fig. 1 umfasst die Ausformung einen Krümmungsradius der Oberseite des Gehäuses 101, sodass auftropfendes Wasser seitlich abfließen kann.

Weitere Vorteile des Elektronikgehäuses 100 und insbesondere der Schwenkvorrichtung 200 des Elektronikgehäuses 100 werden unter Bezugnahme auf Fig. 2 erläutert.

Fig. 2 zeigt eine Schnittansicht eines Teils der Schwenkvorrichtung 200 des Elektronikgehäuses 100 aus Fig. 1.

Insbesondere wird in Fig. 2 eine Rückfläche der Schwenkvorrichtung dargestellt, die einem Gehäuseelement 302 zugewandt, also nicht sichtbar, ist, wenn die Schwenkvorrichtung mit einem Trägerkörper verbunden ist.

Daher sind mittig die rückseitigen Halteabschnitte 203 der Schwenkvorrichtung 200 zu erkennen, an welchen das Befestigungsmittel 204 (nicht gezeigt) zwecks der Befestigung von Kabeln 401 am Kabelbefestigungsabschnitt 201 eingreift.

Im gezeigten Ausführungsbeispiel sind diese Halteabschnitte 203 als Nuten im Material der Schwenkvorrichtung 200 ausgeführt. Die in Fig 2. erkennbare offene Fläche wird, wenn die Schwenkvorrichtung 200 mit einem Trägerkörper, beispielsweise einem Gehäuseelement 302 einer Gehäusebaugruppe 300, verbunden ist, durch dasselbe überdeckt. Es bildet sich somit ein Durchgang, durch welchen das Befestigungsmittel 204 geführt werden kann.

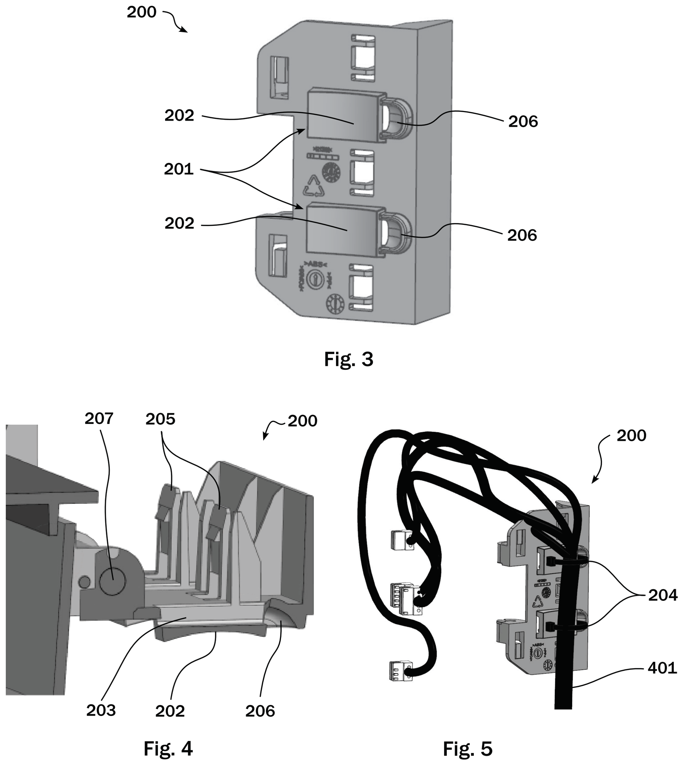

An einem Ende der Halteabschnitte 203 befinden sich jeweils die Ausrichtabschnitte 206, die eine leichte Montage des Befestigungsmittels 204 erlauben. Für eine nähere Beschreibung der Halteabschnitte 203 und der Ausrichtabschnitte 206 wird auf die Beschreibung zu Fig. 4 verwiesen.

Weiterhin ist in der Ansicht in Fig. 2 die Positionierungshilfe 208 dargestellt. Im gezeigten Ausführungsbeispiel ist die Positionierungshilfe 208 durch zwei zylinderförmige Ausformungen auf der rückwärtigen Seite der Schwenkvorrichtung 200 gebildet.

Diese zylinderförmigen Ausformungen greifen in einer Verbindungsposition in entsprechende Aussparungen am Trägerkörper, beispielsweise am Gehäuseelement 302, ein.

Auf diese Weise wird die Verbindung der Schwenkvorrichtung 200 mit dem Trägerkörper erleichtert und eine fehlerhafte Positionierung vermieden. Besonders vorteilhaft ist die Positionierungshilfe 208 derart ausgebildet, dass sie bei einer Verdrehung und/oder Verkippung der Schwenkvorrichtung 200 nicht passend eingreifen kann, um eine Verbindung der Schwenkvorrichtung 200 mit dem Trägerkörper in einer solchen unerwünschten Position zu vermeiden.

Da das Eingreifen der Positionierungshilfe 208 im Trägerkörper in einer spürbaren Lageänderung der Schwenkvorrichtung 200 resultiert, kann diese insbesondere leicht an Positionen ohne direkten Sichtkontakt, also blind, mit dem Trägerkörper verbunden werden. Dadurch wird die Montage des Elektronikgehäuses 100 weiter erleichtert.

Diese Art der Montage wird weiter erleichtert, wenn der Befestigungsschnittstellenabschnitt 205 und der entsprechende Aufnahmeabschnitt am Gehäuseelement, das den Trägerkörper bildet, sicher gegen Verdrehen ausgebildet sind.

Fig. 3 zeigt eine Ansicht der Außenseite eines Teils eines vorteilhaften Ausführungsbeispiels der Schwenkvorrichtung 200.

Die in Fig. 3 gezeigte Seite der Schwenkvorrichtung 200 liegt außen, das heißt sie ist sichtbar, wenn die Schwenkvorrichtung 200 mit dem Trägerkörper, beispielsweise einem Gehäuseelement 302 einer Gehäusebaugruppe 300, verbunden ist.

Das in Fig. 3 gezeigte Ausführungsbeispiel umfasst Kabelbefestigungsabschnitte 201, welche mittig zu erkennen sind. Mittels dieser können Kabel 401, beziehungsweise Abschnitte von Kabeln 401, an der Schwenkvorrichtung 200 befestigt werden.

Die Kabelbefestigungsabschnitte 201 umfassen dabei jeweils eine konkave Auflagefläche 202, einen rückseitigen Halteabschnitt 203 (nicht in Fig. 3 dargestellt) sowie einen Ausrichtabschnitt 206 für ein Befestigungsmittel 204.

Die vorteilhafte Ausführungsform mit zwei Kabelbefestigungsabschnitten 201 steigert dabei weiter die Einsatzflexibilität, da mehr Freiheiten bei der Kabelführung gegeben sind. Somit können einerseits mehr Komponenten verkabelt werden, andererseits können auch kompliziertere Verkabelungskonzepte realisiert werden, da unterschiedliche Kabel 401 mittels einer Befestigung an unterschiedlichen Kabelbefestigungsabschnitten 201 auch in unterschiedliche Richtungen geleitet werden können.

Fig. 4 zeigt einen Querschnitt eines vorteilhaften Ausführungsbeispiels der Schwenkvorrichtung 200 senkrecht zu einer Haupterstreckungsrichtung der Schwenkvorrichtung 200.

Die Darstellung in Fig. 4 zeigt den Befestigungsschnittstellenabschnitt 205, welcher als elastischer Hakenabschnitt ausgeführt ist, genauer. Die elastischen Haken sind eingerichtet, in entsprechende Hakenöffnungen am Trägerkörper (nicht gezeigt) einzugreifen, um die Schwenkvorrichtung 200 mit demselben lösbar zu verbinden.

Der elastische Hakenabschnitt erlaubt so eine stabile und zuverlässige Verbindung der Schwenkvorrichtung 200 mit Trägerkörper ohne ein Entfernen der Schwenkvorrichtung 200 vom Trägerkörper zu erschweren. Die elastischen Haken können bei einer Demontage leicht gelöst werden, wodurch die Schwenkvorrichtung 200 ohne Rückstände am Trägerkörper wieder entfernt werden kann. Dadurch können Komponenten beispielsweise im Störungsfall einfach und schnell getauscht werden, wodurch Ausfallzeiten und/oder Wartungszeiten reduziert werden.

Anhand von Fig. 4 soll auch die Befestigung von Kabeln 401 an der Schwenkvorrichtung 200 erläutert werden.

Soll ein Kabel 401 an der Schwenkvorrichtung 200 befestigt werden, wird dieses an der konkaven Auflagefläche 202 aufgelegt. Die konkave Form der Auflagefläche verhindert dabei ein seitliches Wegrutschen und erlaubt insbesondere die zeitgleiche Auflage mehrerer Kabel, auch unterschiedlicher Durchmesser.

In einem weiteren Schritt wird ein Befestigungsmittel 204, beispielsweise ein Kabelbinder, von der linken Seite unter die konkave Auflagefläche 202 in den Halteabschnitt 203 eingeführt und durch diesen durchgeführt, bis das Befestigungsmittel 204 den Ausrichtabschnitt 206 kontaktiert. Dieser sorgt nun einerseits dafür, dass das Befestigungsmittel 204 nicht im Halteabschnitt 203 stecken bleibt, andererseits führt der Ausrichtabschnitt 206 das Befestigungsmittel 204 wieder auf die Vorderseite der Schwenkvorrichtung 200. Weiterhin ist der Ausrichtabschnitt 206 auch eingerichtet, das Befestigungsmittel so zu führen, dass es einfach gegriffen werden kann.

Im gezeigten Ausführungsbeispiel weist der Ausrichtabschnitt 206 hierzu einen bogenförmigen Umlenkabschnitt auf, an dem ein durch den Halteabschnitt 203 geführtes Befestigungsmittel umgelenkt wird. Insbesondere wird ein Befestigungsmittel 204, welches parallel zu einer Haupterstreckungsrichtung des Halteabschnittes 203 durchgeführt wurde, so ausrichtet, dass es beim Verlassen des Ausrichtabschnittes 206 in einer Richtung nicht parallel zur Haupterstreckungsrichtung des Halteabschnittes 203 verläuft.

In vorteilhaften Ausgestaltungen können die Enden des Ausrichtabschnitts 203 zueinander Winkel im Bereich von 50° bis 130° aufweisen. Weiter bevorzugt können die Enden zueinander einen Winkel im Bereich von 70° bis 100° aufweisen.

Dadurch ist je nach Wahl des Winkels die Möglichkeit gegeben, unterschiedliche Befestigungsmittel 204 auszurichten. Der Winkel ist dabei nach den Beschaffenheiten der auszurichtenden Befestigungsmittel 204 zu wählen. Insbesondere Dicke oder Steifigkeit der umzulenkenden Befestigungsmittel 204 können einen großen Einfluss auf einen minimalen Winkel haben, bei dem ein Befestigungsmittel noch zufriedenstellend ausgerichtet wird.

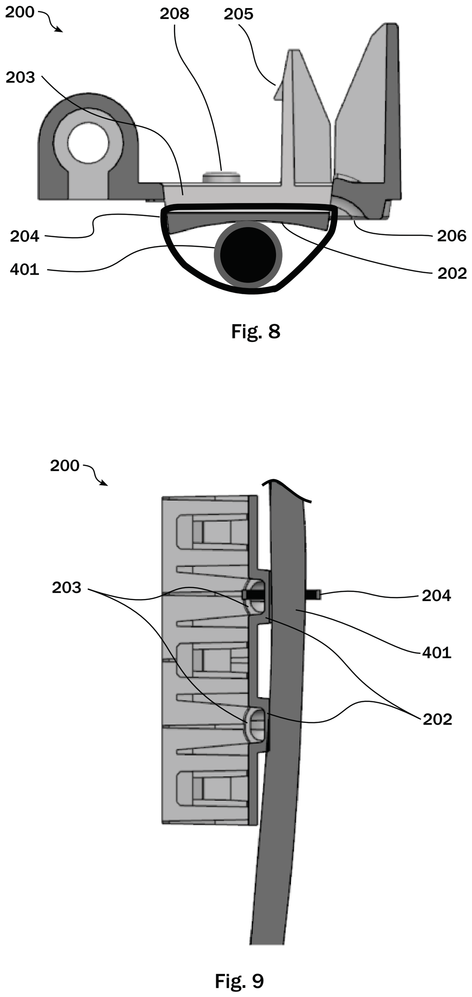

Das Befestigungsmittel 204 umläuft zur Befestigung eines oder mehrerer Kabel 401 also die konkave Auflagefläche 202 in einer Umfangsrichtung, wobei es sich durch den rückseitigen Halteabschnitt 203 und den Ausrichtabschnitt 206 erstreckt. Hierzu sei auch auf Fig. 8 verwiesen.

Der Ausrichtabschnitt 206 erlaubt es dabei auf vorteilhafte Weise, Befestigungsmittel 204 auch an schwer zugänglichen Orten an der Schwenkvorrichtung 200 zum Einsatz zu bringen, um Kabel 401 an derselben zu befestigen.

Besonders vorteilhaft können Befestigungsmittel auch vor einer Verbindung der Schwenkvorrichtung 200 mit dem Trägerkörper durch den Halteabschnitt 203 geführt werden. Auf diese Weise kann die spätere Montage des Elektronikgehäuses 100 und der entsprechenden Verkabelung weiter beschleunigt werden, da ein Einfädeln und/oder Durchführen von Befestigungsmitteln 204 gänzlich vermieden wird, sobald die Schwenkvorrichtung 200 nicht länger gut zugänglich ist.

Fig. 5 zeigt beispielhaft und schematisch an einer Schwenkvorrichtung 200 befestigte Kabel 401.

Gezeigt ist erneut die außenliegende Seite der Schwenkvorrichtung 200. Ein Trägerkörper ist nicht dargestellt.

In der vorteilhaften Ausgestaltung von Fig. 5 werden mehrere Kabel dünneren Querschnitts zu einem dicken Kabel zusammengefasst, welches an den Kabelbefestigungsabschnitten 201 der Schwenkvorrichtung 200 befestigt ist. Das dicke Kabel kann entweder in Form einer Bündelung einzelner Litzen zu einem Strang ausgeführt sein oder aber die in Form einer Mantelleitung bei der vielen einzelnen Litzen von einem gemeinsamen Mantel umgeben sind.

Die Aufspaltung in mehrere Kabel 401 kleineren Querschnitts erfolgt dabei auf Seiten des Elektronikgehäuses 100 (nicht dargestellt). Die dargestellten Stecker an den Kabeln sind entsprechend mit einer oder mehreren elektrischen Leiterplatten verbunden (ebenfalls nicht dargestellt).

Hierzu kommen Kabelbinder als Befestigungsmittel 204 zum Einsatz. Diese bieten den Vorteil, dass sie unter Zerstörung der Kabelbinder schnell wieder entfernt werden können, beispielsweise um die Verkabelung zu korrigieren oder ein oder mehrere Kabel 401 zu tauschen.

Weiterhin ist in Fig. 5 schematisch gezeigt, dass Kabel 401 mit Überlängen konfektioniert und an der Schwenkvorrichtung 200 befestigt wurden, wobei sich insbesondere Kabelüberlängen Elektronikgehäuse-seitig der Befestigung an der Schwenkvorrichtung 200 befinden. Auf diese Weise kann sichergestellt werden, dass das Elektronikgehäuse 100 auch bei verbundenen Kabeln 401 geschwenkt werden kann, im Wesentlichen ohne dass Kräfte, insbesondere Zugkräfte, auf die Kabelverbindungen wirken.

Dadurch wird eine flexible Positionierung des Elektronikgehäuses 100 möglich, da bei der Positionierung keine Rücksicht auf etwaige Sicht- und oder Zugangsbehinderungen durch das montierten Elektronikgehäuse 100 genommen werden muss. Blockiert das montierte Elektronikgehäuse 100 die Sicht auf oder den Zugang zu anderen Baugruppen und/oder Elementen, kann er aus dem Weg geschwenkt werden. Sind die Kabel 401 dabei entsprechend inklusive der geschilderten Überlängen an der Schwenkvorrichtung 200 befestigt, besteht keine Gefahr beim Schwenken des Elektronikgehäuses 100 eine Kabelverbindung zu unterbrechen.

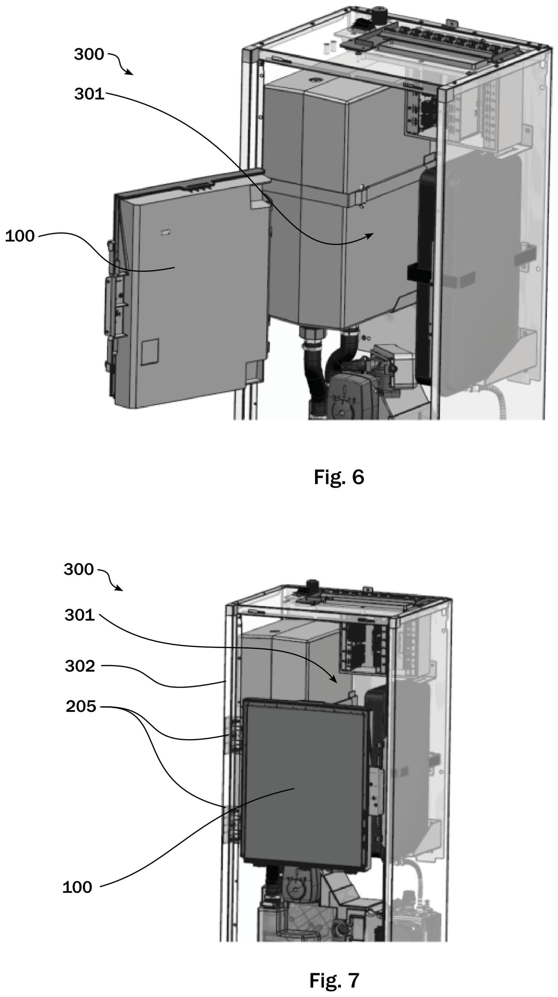

Eine solche mögliche Schwenkbewegung ist in den Fig. 6 und 7 dargestellt.

Beide Figuren zeigen dieselbe vorteilhafte Ausführung einer Gehäusebaugruppe 300. Die Gehäusebaugruppe 300 umfasst dabei mehrere Gehäuseelemente, die zusammen einen Innenraum definieren und ein Elektronikgehäuse 100. Eine vorteilhafte Ausführung des Elektronikgehäuses 100 in einem geschlossenen Zustand ist dabei mittels der Schwenkvorrichtung 200 schwenkbar an einem Gehäuseelement befestigt, welches somit als Trägerkörper für das Elektronikgehäuse 100 fungiert.

In Fig. 6 ist das Elektronikgehäuse 100 in einer ausgeschwenkten Position gezeigt. Bei dieser Position handelt es sich beispielsweise um eine Serviceposition, in der der Zugang zum Innenraum 301 der Gehäusebaugruppe 300 freigegeben ist. Ein Zugang zu Elementen und Baugruppen im Innenraum 301 ist nicht durch das Elektronikgehäuse 100 versperrt.

Wird der Zugang nicht länger benötigt, kann das Elektronikgehäuse 100 wieder eingeschwenkt werden. Diese Position ist in Fig. 7 dargestellt.

Das Elektronikgehäuse 100 befindet sich jetzt beispielweise in einer Betriebsposition. In dieser Position befindet sich der Elektronikgehäuse 100 komplett im Innenraum 301 der Gehäusebaugruppe 300. Diese Position des Elektronikgehäuses 100 ist platzsparend, ein Zugang zu Elementen und Baugruppen im Innenraum 301 ist jedoch erschwert.

Neben der Platzersparnis, die sich durch die Schwenkbarkeit des Elektronikgehäuses 100 im Zuge der Kabelbefestigung mit Kabelüberlängen an der Schwenkvorrichtung 200 ergibt, erlaubt die gewonnene Flexibilität bei der Positionierung des Elektronikgehäuses 100 auch besonderes Augenmerk auf die elektromagnetische Verträglichkeit zu legen.

Das Elektronikgehäuse 100 kann vorteilhaft an einem Ort im Innenraum 301 einer Gehäusebaugruppe 300 untergebracht werden, der möglichst weit entfernt von Störquellen, wie Motoren, Pumpen und/oder leistungselektronischen Bauteilen liegt.

Dadurch eignet sich das Elektronikgehäuse 100 besonders, elektronische Leiterplatten mit empfindlichen elektrischen Bauteilen, also beispielsweise elektrische Leiterplatten mit Steuerelektronik, aufzunehmen.

Besonders vorteilhaft ist das Gehäuse 101 des Elektronikgehäuses 100 hierfür abgeschirmt.

Fig. 8 zeigt einen Querschnitt eines vorteilhaften Ausführungsbeispiels der Schwenkvorrichtung 200 mit daran befestigtem Kabel 401, senkrecht zu einer Haupterstreckungsrichtung des Kabels 401.

Wie bereits vorstehend erläutert, kann ein Kabel 401 an der Schwenkvorrichtung 200 befestigt werden. Dazu wird das zu befestigende Kabel 401 zunächst auf der konkaven Auflagefläche 202 aufgelegt, beziehungsweis mit dieser in Kontakt gebracht.

In einem weiteren Schritt wird das Befestigungsmittel 204 in den Halteabschnitt 203, welcher sich rückseitig der konkaven Auflagefläche 202 befindet, eingeführt.

Das Einführen des Befestigungsmittels 204 erfolgt insbesondere nicht an der Seite des Halteabschnitts 203, an der sich der Ausrichtabschnitt 206 befindet.

Befinden sich vorteilhaft an beiden Enden des Halteabschnittes 203 Ausrichteabschnitte 206, kann jeder der Ausrichteabschnitte 206 genutzt werden, um ein Befestigungsmittel in den Halteabschnitt 203 einzuführen. Insbesondere kann diesfalls je nach Erreichbarkeit ein Ausrichteabschnitt 206 ausgewählt werden.

Das Befestigungsmittel 204 wird nun durch den Halteabschnitt 203 geführt, bis es durch den Ausrichtabschnitt 206 wieder auf die Vorderseite, beziehungsweise die Seite der Schwenkvorrichtung 200 geführt wird, auf der sich die konkave Auflagefläche 202 befindet.

Dank der Umleitung des durchgeführten Endes des Befestigungsmittels 204, ist dieses nun einfach zugänglich und kann beispielsweise händisch gegriffen werden, um das Befestigungsmittel 204 zu verschließen und so das Kabel 401 am Kabelbefestigungsabschnitt 201 der Schwenkvorrichtung 200 zu befestigen.

In Fig. 8 ist schematisch ein Kabelbinder als Befestigungsmittel 204 dargestellt. Dieser ist so angezogen worden, dass er das Kabel 401 auf die konkave Auflagefläche 202 drückt. Das Festziehen eines Kabelbinders wird insbesondere auch durch den Ausrichtabschnitt 206 erleichtert, der das festzuziehende Ende des Kabelbinders einfach zugänglich macht und so beispielsweise auch ein einfaches Justieren der Kabelbinderposition ermöglicht.

Vorteilhaft kann ein Befestigungsmittel 204, insbesondere ein Kabelbinder, auch eingesetzt werden um mehrere Kabel 401 an der Schwenkvorrichtung 200 zu befestigen.

Wird ein Kabelbinder als Befestigungsmittel 204 eingesetzt, schränkt der auf der konkaven Auflagefläche 202 zur Verfügung stehende Anlageplatz nicht die Menge der Kabel 401 ein, die an der entsprechenden Schwenkvorrichtung befestigt werden können. In anderen Worten können mit einem Kabelbinder auch mehr Kabel 401 an einer Schwenkvorrichtung befestigt werden, als gleichzeitig an der konkaven Auflagefläche 202 aufliegen können.

Weiterhin können auch Kabel 401 an der Schwenkvorrichtung befestigt werden, deren Durchschnitt so groß ist, dass er die konkave Auflagefläche 202 in der Schnittansicht seitlich überragt.

Fig. 9 zeigt einen Querschnitt eines vorteilhaften Ausführungsbeispiels der Schwenkvorrichtung mit daran befestigtem Kabel, parallel zu einer Haupterstreckungsrichtung des Kabels.

In dem in Fig. 9 dargestellten Ausführungsbeispiel der Schwenkvorrichtung 200 ist zu erkennen, dass das befestigte Kabel 401 lediglich mittels eines Befestigungsmittels 204 befestigt ist. Dazu greift das Befestigungsmittel 204 an einem der zwei dargestellten Halteabschnitte 203 ein. Der Verlauf des Kabels 401 wird also lediglich im oberen Bereich der Schwenkvorrichtung 200 eingeschränkt, wodurch die Verkabelung abseits der Schwenkvorrichtung erleichtert wird.

Weiterhin kann das Kabel 401 auf diese Weise gegebenenfalls von der unteren konkaven Auflagefläche 202 entfernt werden, sodass dort weitere Kabel 401 aufgelegt und befestigt werden können. Dadurch kann eine flexiblere Verkabelung erreicht werden, ohne jedoch auf die dargelegten Vorteile der Befestigung von Kabeln 401 an der Schwenkvorrichtung 200 des Elektronikgehäuses 100 verzichten zu müssen.

Wird für ein Kabel 401, beispielsweise aufgrund eines großen Durchmessers oder der Bündelung vieler unterschiedlicher Kabel 401 eine besonders sichere Fixierung an der Schwenkvorrichtung 200 benötigt, kann das Kabel 401 auch mittels mehrerer Befestigungsmittel 204 an der Schwenkvorrichtung befestigt werden. Die Befestigungsmittel 204 können dabei insbesondere jeweils an unterschiedlichen Halteabschnitten 203 eingreifen. Werden die Befestigungsmittel 204 entsprechend dimensioniert ausgewählt, können auch zwei oder mehr Befestigungsmittel 204 am selben Halteabschnitt 203 eingreifen, um ein Kabel 401 an der Schwenkvorrichtung 200 zu befestigen.

Vorstehend wurden Ausführungsbeispiele der vorliegenden Erfindung sowie deren Vorteile detailliert unter Bezugnahme auf die beigefügten Figuren beschrieben.

Es wird erneut hervorgehoben, dass die vorliegende Erfindung in keiner Weise auf die vorstehend beschriebenen Ausführungsbeispiele und deren Ausführungsmerkmale begrenzt ist. Die Erfindung umfasst weiterhin Modifikationen der genannten Ausführungsbeispiele, insbesondere diejenigen, die aus Modifikationen und/oder Kombinationen einzelner oder mehrerer Merkmale der beschriebenen Ausführungsbeispiele im Rahmen des Schutzumfanges der unabhängigen Ansprüche hervorgehen.

### Liste der Bezugszeichen

- 100: Elektronikgehäuse
- 101: Gehäuse des Elektronikgehäuses
- 102: Aufnahmeraum
- 200: Schwenkvorrichtung
- 201: Kabelbefestigungsabschnitt
- 202: konkave Auflagefläche
- 203: Halteabschnitt
- 204: Befestigungsmittel
- 205: Befestigungsschnittstellenabschnitt
- 206: Ausrichtabschnitt
- 207: Verbindungsmittel
- 208: Positionierungshilfe
- 300: Gehäusebaugruppe
- 301: Innenraum
- 302: Gehäuseelement
- 400: elektrische Leiterplatte
- 401: Kabel

## Patentansprüche

1. Schwenkbares Elektronikgehäuse (100) zur Aufnahme von elektrischen Leiterplatten (400), umfassend
- ein Gehäuse (101), das einen Aufnahmeraum (102) umgibt, in dem zumindest eine elektrische Leiterplatte (400) aufgenommen werden kann; und
- zumindest eine Schwenkvorrichtung (200) zur Befestigung des Gehäuses (101) an einem Trägerkörper;
wobei die zumindest eine Schwenkvorrichtung (200) in einem am Trägerkörper befestigten Zustand zumindest eine Schwenkbewegung des Gehäuses (101) relativ zum Trägerkörper gestattet;
**dadurch gekennzeichnet, dass**
die zumindest eine Schwenkvorrichtung (200) eine kabelführende Schwenkvorrichtung (200) ist, die ausgelegt ist, einen Abschnitt eines Kabels (401), das aus einer Umgebung des Gehäuses (101) in den Aufnahmeraum(102) verläuft, zu führen,
wobei die kabelführende Schwenkvorrichtung (200) zumindest einen Kabelbefestigungsabschnitt (201) umfasst, der
eine konkave Auflagefläche (202), auf der der Abschnitt des Kabels (401) aufliegen kann, und einen unterhalb der Auflagefläche (202) liegenden Halteabschnitt (203) aufweist, an dem ein Befestigungsmittel (204) angreifen kann, um den auf der Auflagefläche (202) aufliegenden Abschnitt des Kabels (401) an der Schwenkvorrichtung (200) zu befestigen.

2. Elektronikgehäuse (100) nach Anspruch 1, wobei die Schwenkvorrichtung (200) einen Befestigungsschnittstellenabschnitt (205) umfasst, der derart auf einen Aufnahmeabschnitt des Trägerkörpers angepasst ist, dass die Schwenkvorrichtung (200) am Trägerkörper form- und/oder kraftschlüssig befestigt ist, wenn der Befestigungsschnittstellenabschnitt (205) und der Aufnahmeabschnitt in Wechselwirkung gebracht sind, wobei der Befestigungsschnittstellenabschnitt (205) und der Aufnahmeabschnitt vorzugsweise zerstörungsfrei voneinander lösbar sind.

3. Elektronikgehäuse nach Anspruch 2, wobei der Befestigungsschnittstellenabschnitt (205) und der Aufnahmeabschnitt derart ausgestaltet sind, dass diese durch elastische Verformung des Befestigungsschnittstellenabschnitts (205) und/oder des Aufnahmeabschnitt voneinander lösbar sind.

4. Elektronikgehäuse (100) nach Anspruch 3, wobei der Befestigungsschnittstellenabschnitt (205) und der Aufnahmeabschnitt als Einrastmechanismus ausgeführt sind, bei dem ein elastischer Rast- oder Hakenabschnitt (205) in eine auf diesen angepasste Rast- bzw. Hakenöffnung eingreift, wenn der Befestigungsschnittstellenabschnitt (205) und der Aufnahmeabschnitt in Wechselwirkung gebracht sind.

5. Elektronikgehäuse (100) nach einem der vorstehenden Ansprüche, wobei der zumindest eine Kabelbefestigungsabschnitt (201) einen Ausrichtabschnitt (206) zur Führung und/oder Ausrichtung des Befestigungsmittels (204) aufweist, der das Befestigungsmittel (204) bei einer Bewegung des Befestigungsmittels relativ zum Halteabschnitt (203) führt und/oder gegenüber dem Halteabschnitt (203) ausrichtet, wenn das Befestigungsmittel in Wechselwirkung mit dem Ausrichtabschnitt (206) gebracht ist.

6. Elektronikgehäuse (100) nach einem der vorstehenden Ansprüche, wobei der Halteabschnitt (203) nutförmig ausgebildet ist und der Ausrichtabschnitt (206) vorzugsweise durch einen bogenförmigen Umlenkabschnitt gebildet ist, an dem ein relativ zum Halteabschnitts (203) geführtes Befestigungsmittel (204) in Richtung der Auflagefläche umgelenkt wird, vorzugsweise stehen Enden des Umlenkabschnitts in einem Winkel von 50° bis 130° zueinander, besonders bevorzugt in einem Winkel von 70° bis 100°.

7. Elektronikgehäuse (100) nach einem der vorstehenden Ansprüche, wobei die Schwenkvorrichtung (200) mehrteilig ausgeführt ist und zumindest einen trägerkörperseitigen Teil und einen gehäuseseitigen Teil umfasst, die gegeneinander schwenkbar sind und die miteinander über ein Verbindungsmittel (207) lösbar verbunden sind, wobei vorzugsweise der trägerkörperseitige Teil den zumindest einen Kabelbefestigungsabschnitt (201) aufweist.

8. Elektronikgehäuse (100) nach einem der vorstehenden Ansprüche, wobei die Schwenkvorrichtung (200) zusätzlich eine Positionierungshilfe (208) umfasst, mittels der die Schwenkvorrichtung (200) in einer Verbindungsposition an und/oder im Trägerkörper positioniert werden kann.

9. Elektronikgehäuse (100) nach einem der vorstehenden Ansprüche, wobei die Schwenkvorrichtung (200) einen oder mehrere weitere Kabelbefestigungsabschnitte (201) umfasst, die jeweils eine konkave Auflagefläche (202), auf der der Abschnitt des Kabels (401) aufliegen kann, und einen unterhalb der Auflagefläche (202) liegenden Halteabschnitt (203) aufweist, an dem ein Befestigungsmittel (204) angreifen kann, um den auf der Auflagefläche (202) aufliegenden Abschnitt des Kabels (401) an der Schwenkvorrichtung (200) zu befestigen.

10. Elektronikgehäuse (100) nach Anspruch 9, wobei der zumindest eine Kabelbefestigungsabschnitt (201) und der eine oder die mehreren weiteren Kabelbefestigungsabschnitte (201) symmetrisch angeordnet sind.

11. Elektronikgehäuse (100) nach einem der vorstehenden Ansprüche, wobei das Elektronikgehäuse (100) eine oder mehrere weitere Schwenkvorrichtung (200) umfasst.

12. Schwenkvorrichtung eines Elektronikgehäuse (100) nach einem der Ansprüche 1 bis 11.

13. Schwenkbare Elektronikvorrichtung, umfassend:
- ein schwenkbares Elektronikgehäuse (100) nach einem der Ansprüche 1 bis 11; und
- zumindest eine elektrische Leiterplatte (400), die im Aufnahmeraum (102) des Elektronikgehäuses (100) aufgenommen ist.

14. Gehäusebaugruppe (300) zum Einsatz in einer Klimatisierungseinheit, umfassend:
- ein oder mehrere Gehäuseelemente (302), die zusammen einen Innenraum definieren, und
- ein Elektronikgehäuse (100) nach einem der Ansprüche 1 bis 11;
wobei das Elektronikgehäuse (100) über seine Schwenkvorrichtung (200) an einem der ein oder mehreren Gehäuseelemente (302), das als Trägerkörper für das Elektronikgehäuse fungiert, schwenkbar befestigt ist, vorzugsweise derart, dass das Elektronikgehäuse (100) zumindest in einer ersten Schwenkstellung des Elektronikgehäuses (100) teilweise oder ganz im Innenraum liegt.

15. Klimatisierungseinheit, umfassend:
- eine Gehäusebaugruppe (300) nach Anspruch 13;
- zumindest eine elektrische Leiterplatte (400), die im Aufnahmeraum (102) des Elektronikgehäuses (100) aufgenommen ist; und
- zumindest ein Kabel (401), das an der zumindest einen Leiterplatte (400) angeschlossen ist und über die kabelführende Schwenkvorrichtung (200) aus dem Aufnahmeraum (102) herausgeführt ist;
wobei das zumindest eine Kabel (401) auf der Auflagefläche (202) aufliegt und mittels eines am Halteabschnitt (203) angreifenden Befestigungsmittels (204) an der Schwenkvorrichtung (200) befestigt ist.
